# EUROPEAN PATENT APPLICATION

(11) **EP 2 058 866 A2**
(43) Date of publication of application: **13.05.2009**
(21) Application number: 08253659.0
(22) Date of filing: 07.11.2008
(51) Int. Cl.: H01L 31/048, H01L 31/0236

(54) **Solar cell sheet and a method for the preparation of the same**

(30) Priority: 07.11.2007 CN 200710166978
(71) Applicant: E. I. Du Pont de Nemours and Company, Wilmington, DE 19898 (US)
(72) Inventor: Ruofei, Zhao, Pudong New District Shanghai 201203 (CN); Guangjun, Yin, Pudong New District Shanghai 201203 (CN); Changming, Ye, Pudong New District Shanghai 201203 (CN)
(74) Representative: Matthews, Derek Peter

(57) **Abstract**

The present invention discloses a solar cell sheet, comprising a back sheet, a plastic front sheet and a solar cell circuit between the back sheet and the plastic front sheet, wherein the plastic front sheet possesses a first light receiving surface and a second surface adjacent to the solar cell circuit, wherein the second surface possesses a surface texture capable of improving light trapping property. It also discloses a method for the preparation of the same.

## Description

### Field of the Invention

The present invention relates to a novel type of solar cell sheet, which possesses high output power. The present invention also relates to a method for the preparation of the novel solar cell sheet.

### Background of the Invention

With global warming, the government of each country places higher requirements for energy saving and pollution discharge reduction. Therefore, seeking new energy resources to replace petroleum fossil fuel has become an imminent problem that needs to be addressed immediately.

Solar energy is clean and pollution free. Moreover, it is inexhaustible in supply and always available for use. Currently, the utilization of solar energy is by converting the solar energy into electrical energy through a solar cell sheet. Then the electrical energy is used to drive the devices such as an electrical water oven, an electrical car, and a satellite device, etc.

Solar cell sheet refers to a photonics device that directly produces electricity from light, especially sunlight. Currently, an available crystalline silicon based solar cell sheet mainly comprises a back sheet, a solar cell circuit, a packaging material, and a front sheet.

The function of a packaging material in a solar cell sheet ( for example ethylene - vinyl acetate plastic film ) is combining the front sheet and the back sheet together. During the lamination pressing process at about 150 °C, the ethylene - vinyl acetate melt can flow into the spaces of a solar cell and seal the solar cell. An electrically conductive adhesive can also be used to connect each parts of the solar cell.

The function of a front sheet of a solar cell sheet is mainly preventing the cell from mechanical and aging effects. In order to sufficiently utilize the sunlight, the front sheet must have high transmittance in a certain spectrum range, for example for a crystalline silicon cell, light wavelength range is 400 - 1100 nm. Currently available front sheets of solar cell sheet mainly consist of glass (typically ferric taconite tempered glass with 3 - 4 mm thick). It is placed on the outer surface of the solar cell. Its transmittance in the range of 400 - 1100 nm is 90 to 92 % and as the light receiving surface it is directly exposed to sunlight. Used as front sheet, glass possesses advantage of high mechanical strength. However, the disadvantages of glass are that compared with many plastic materials, its transmittance is lower, it is heavier, its impact strength is worse, and special care must be taken less it breaks during transportation, installation, and application. For example, in a severe weather, e.g, hail, the exposed front sheet may be broken due to the impact.

In order to overcome the disadvantages, the Chinese patent CN 02143582.0 disclosed the invention using plastic materials as the front sheet and glass as the back sheet. Although plastic materials as front sheet have high normal light transmittance, when the incident angle of sunlight is relatively high, the untreated plastic materials have relatively worse light trapping property. The sunlight penetrating the front plastic sheet and entering the inside of solar cell can easily penetrate The plastic front sheet and emit out from the inside of the solar cell when reflected by the inner parts of the solar cell ( for example ethylene - vinyl acetate copolymer layer, solar cell circuit ). Thus, it limits the sunlight utilization efficiency. Therefore, there is still a lot of room for improving the output power of the solar cell using plastic materials as the front sheet.

In addition, the back sheet of the solar sheet is mainly used as a barrier layer to prevent the solar cell and packing materials or electrical conductive adhesives from exposure to moisture and oxygen. During the process of solar cell assembly, the back sheet functions as the mechanical protection and for preventing indentation and scratching and acts for insulation. Although typical back sheet of a solar cell can meet the above mentioned typical requirements, there is still a lot of room for improving the sunlight utilization efficiency.

One goal of the present invention is to provide a novel solar cell sheet, which possesses improved sunlight trapping efficiency. Therefore, it possesses improved output power. Another goal of the present invention is to provide a method for the preparation of the novel solar cell.

### Summary of the Invention

The first part of the present invention provides a solar cell sheet, comprising a back sheet, a front sheet, and a solar cell circuit between the back sheet and the front sheet. The front sheet has the light receiving first surface and the second surface adjacent to the circuit of the solar cell, wherein the second surface has a surface texture which can improve light trapping ability.

The second part of the present invention provides a solar cell sheet, comprising a back sheet, a front sheet, and a solar cell circuit between the back sheet and front sheet. The back sheet has the first surface and the second surface adjacent to the circuit of solar cell, wherein the second surface has a surface texture which can improve light trapping property.

The third part of the present invention provides a method for the preparation of the solar cell, comprising:
Providing a back sheet;
Providing a front sheet, the front sheet possesses first surface and the second surface;
Forming a surface texture capable of improving the light trapping property on the second surface of the front sheet, and
Placing a solar cell circuit between the back sheet and front sheet.

The fourth part of the present invention provides a method for the preparation of a solar cell sheet, comprising:
Providing a back sheet, the back sheet possesses first surface and the second surface;
Providing a front sheet;
Forming a surface texture capable of improving the light trapping property on the second surface of the back sheet, and
Placing a solar cell circuit between the back sheet and front sheet.

### Brief Description of the Drawings

In the following paragraphs, the invention will be described in detail by using the attached Figures.
Figure 1 is the scheme of a currently available typical solar cell sheet of crystalline silicon.
Figure 2 is the scheme of an example of the solar cell sheet of crystalline silicon of the present invention.
Figure 3 is the scheme of an example of the second surface texture of the front sheet or the back sheet of the solar cell sheet of crystalline silicon of the present invention.
Figure 4 is the profile of the surface texture of Figure 3.
Figure 5 is the scheme of another example of the second surface texture of the front sheet or the back sheet of the solar cell sheet of crystalline silicon of the present invention.
Figure 6 is the profile of the surface texture of Figure 5.
Figure 7 is the scheme of another example of the second surface texture of the front sheet or the back sheet of the solar cell sheet of crystalline silicon of the present invention.
Figure 8 is the profile of the surface texture of Figure 7.
Figure 9 is the three dimensional scheme of another example of the second surface microtreatment of the front sheet or the back sheet of the solar cell sheet of crystalline silicon of the present invention.

### Detailed Description of the Invention

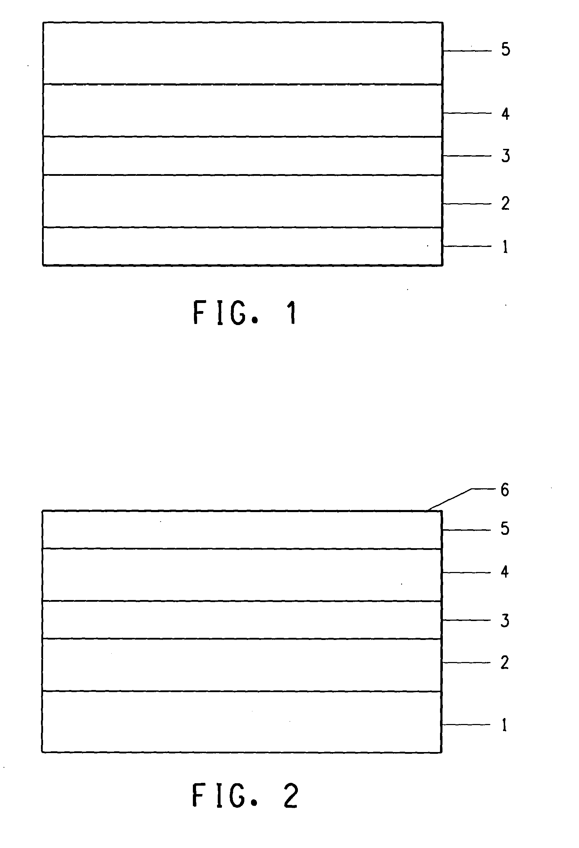

As shown in Figure 1, a currently available solar cell sheet comprises: a back sheet made from plastics 1, packaging material layers 2 and 4, a solar cell circuit 3 and a front sheet made with glass 5. This solar cell sheet has the following disadvantages: the front glass sheet is easy to break due to the foreign forces; the light transmittance is not high enough, and the light trapping property is not good enough.

As shown in Figure 2, the solar cell sheet of the present invention comprises an arbitrarily chosen surface treated back sheet 1, a solar cell circuit 3, and an arbitrarily chosen front sheet 5 that is made from plastics and surface treatment 6. The front sheet 5 possesses a light receiving first surface and the second surface adjacent to the solar cell circuit. In the present invention, the terminology "back sheet" of the solar cell sheet refers the outer surface sheet positioning on the non-light receiving side of the solar cell.

In the present invention, the terminology "front sheet" of the solar cell sheet refers to the outer surface sheet positioning on the light receiving side of the solar cell and the front sheet has a first surface and a second surface. The first surface of the front sheet is a light receiving surface and it faces the sun when in use; the second surface is positioned adjacent to the solar cell circuit of the solar cell. In the present invention, the terminology "positioned adjacent to the solar cell circuit of the solar cell" does not mean that the second surface of the front sheet and / or back sheet directly contact with the solar cell circuit. It may also comprise e.g. a layer of ethylene-vinyl acetate copolymer sealant or an electrically conductive adhesive between the solar cell circuit and the front sheet and / or the back sheet.

In the present invention, the terminology "plastics" used for making the front sheet refers to any polymeric material with normal light transmittance ( for the light wavelength of 350 to 1150 nm ) greater than 88 %, more favorably greater than 92 %, most favorably greater than 96%. The nonrestrictive examples of the this kind of polymeric materials are one of one of the e.g. fluorinated polymers, e.g. perfluoroethylene - perfluoropropylene copolymer, ethylene - tetrafluoroethyelene copolymer, tetrafluoroethylene - perfluoroalkoxy vinyl ether copolymer, tetrafluoroethylene - hexafluoropropylene - vinylidene fluoride terpolymer, poly( vinylidene fluoride ), poly( chloro-trifluoro ethylene ), ethylene - chloro-trifluoro ethylene copolymer; liquid crystalline polymer; poly( ethylene terephthalate ); poly( ethylene naphthalate ); poly( methyl acrylate )s, e.g. poly (methyl (meth)acrylate ), poly (ethyl (meth)acrylate ); polycarbonate, ethylene - vinyl alcohol copolymer; polyurethane etc. as well as the laminated materials with two or more of the above polymers.

In the present invention, the terminology "plastics" used for making the back sheet refers to any polymeric material able to provide structural support for the solar cell sheet. The nonrestrictive examples of this kind of polymeric materials are one of the e.g. fluorinated polymers, e.g. perfluoroethylene - perfluoropropylene copolymer, ethylene - tetrafluoroethyelene copolymer, tetrafluoroethylene - perfluoroalkoxy vinyl ether copolymer, tetrafluoroethylene - hexafluoropropylene - vinylidene fluoride terpolymer, poly( vinylidene fluoride ), poly( chloro-trifluoro ethylene ), ethylene - chloro-trifluoro ethylene copolymer; liquid crystalline polymer; poly( ethylene terephthalate ); poly( ethylene naphthalate ); poly( methyl acrylate )s, e.g. poly (methyl (meth)acrylate ), poly (ethyl (meth)acrylate ); polycarbonate; ethylene - vinyl alcohol copolymer; polyurethane etc. as well as the laminated materials with two or more of the above polymers.

In the present invention, the terminology "solar cell sheet" comprises various solar cells and solar cell modules that can generate electricity when exposed to light. According to the requirements of a specific application, multiple solar cell modules can be combined to obtain the required electric power, voltage, and current, etc. The nonrestrictive examples of the solar cell sheet of the present invention are single crystalline silicon solar cell, polycrystalline solar cell, nanosilicon solar cell, amorphous silicon thin film solar cell, cadmium telluride thin film solar cell, and copper - indium - gallium - selenium thin film solar cell, etc.

In the present invention, the terminology "light trapping property" refers to the performance of improving the quantity of the unit area of incident photons into the solar cell sheet and / or decreasing the quantity of the unit area of the incident photons emitting from the solar cell sheet.

In the present invention, the terminology "possesses a surface texture capable of improving light trapping property" refers to the surface treatment of the plastics surface or the glass surface in order to form a microstructure on the plastic or glass surface. The surface microstructure can allow the incident light to reflect or scatter on the surface, and thus trap the light inside the solar cell sheet. The surface treatment comprises e.g. embossing, microsphere coating, and molding, etc.

### 1. Back sheet

The back sheet of a solar cell is used as the barrier layer for protecting the solar cell and the packing material or electrically conductive adhesive insulate from moisture and oxygen. During the process of assembly of a solar cell sheet, the back sheet can also be used for mechanical protection to avoid scratching etc. and playing a insulating function. There is no special limitation for the back sheet suitable for the solar cell sheet of the present invention and it can be any typical back sheet. The material used for making the back sheet can be glass, plastics, metal etc. One of the major functions is providing structural strength for the solar cell sheet. In one good example of the present invention, glass is used as the back sheet of the solar cell sheet.

There is no special restriction for the thickness of the back sheet, as long as it can provide structural support for the solar cell sheet. The typical technical people in this area can easily decide the required thickness of the back sheet according to a specific application. In one example of the present invention, the solar cell sheet is a single crystal solar cell sheet, and the back sheet is made from glass with 2 - 4 mm in thickness.

When the back sheet is made from transparent plastic materials, in order to improve the photon efficiency of the solar cell sheet and thus increase the whole output power, the second surface of the back sheet can be surface treated to improve its light reflection efficiency.

There is no special restriction for the suitable method for the surface treatment of the back sheet, as long as it can improve the light reflection efficiency of the back sheet to prevent the photons from emitting from the inside of the solar cell.

In one example of the present invention, The solar cell sheet is a single crystal solar cell sheet, and the back sheet is made from plastics with 20 µm - 4 mm in thickness.

In one example of the present invention, the surface treatment of the back sheet comprises embossing the main surface of the back sheet adjacent to the solar cell circuit to form a protruding microstructure. The protruding microstructure comprises continuous or discrete pyramids, frustums of prisms, cones, frustums of cones, and hemispheres, etc.

The height of the protruding microstructure is typically 500 nm to 2 mm, more favorably 2 to 500 µm; the aspect ratio is typically 4 : 1 to 1 : 10, more favorably 1 : 1 to 1 : 4.

In the present invention, the terminology "the height of the protruding microstructure" refers to the distance from the center of the bottom surface of a microstructure to the top point of the microstructure ( in the case of pyramids or cones ), the upper surface ( in the case of frustums of prisms or frustums of cones ) or the highest point ( in the case of hemisphere ).

As described above, the plastic back sheet of the present invention may comprise a continuous or discrete microstructure. In one good example of the present invention, the main surface of the plastic back sheet adjacent to the solar cell circuit comprises a protruding microstructure, wherein The protruding microstructure is evenly distributed on the main surface. The density is 1 - 10⁸ piece / cm², more favorably 10⁴ - 10⁷ piece / cm².

In one good example of the present invention, the main surface of the plastic back sheet adjacent to the solar cell circuit comprises a protruding microstructure, wherein the protruding microstructure forms many discrete islands on the main surface, and is continuously distributed on each island.

In one good example of the present invention, the main surface of The plastic back sheet adjacent to the solar cell circuit comprises a protruding microstructure, wherein The protruding microstructure forms many discrete islands on the main surface, and is evenly discretely distributed on each island. The density is 1 - 10⁸ piece / cm², more favorably 10⁴ - 10⁷ piece /cm².

When a plastics material is used to form the back sheet, the protruding microstructure can be prepared with any typical method. For example, a molder with a female structure texture (e.g. press roller) can be used to prepare a microstructure on the polymer sheet by embossing or a molder can be directly used to mold the microstructure on the polymer sheet. In one example of the present invention, the empty glass beads are coated on the surface of the polymer sheet to form a protruding microstructure.

In order to further improve the light trapping property, in one example of the present invention, a reflective layer is applied on the outer surface of The plastic or glass back sheet (That is, the outer surface of the back sheet is away from The solar cell circuit) to reflect the light emitted from the back sheet back into the inside of the solar cell sheet. There is no special restriction for the reflecting layer. It can be any of the typical reflecting film used in this technical field. For example, it can be an aluminum foil or a film formed with a nanotechnology.

When the back sheet is made from the glass, in order to improve the light trapping property, the surface of the glass back sheet adjacent to the solar cell circuit (that is, the second surface of the glass) can be also treated to make the surface rougher to be beneficial for the diffuse reflection. There is no special restriction for the treatment of the glass back sheet, as long as it can improve the light reflectance of the back sheet in order to prevent the photons from emitting from the inside of the solar cell.

In one example of the present invention, the surface treatment of the glass back comprises heating the glass back sheet to softness and then using a molder to press embossing the major surface (second surface) adjacent to the solar cell circuit to form a protruding microstructure. The protruding structure comprises continuous or discrete pyramids, frustums of pyramids, cones, frustums of cones, hemisphere, or regular or irregular trenches or the combination of two or more of the above shapes.

In another example of the present invention, the melt glass can be directly cast into the molder to form a glass sheet with a texture structure on the major surface (second surface). The protruding structure comprises continuous or discrete pyramids, frustums of pyramids, cones, frustums of cones, hemisphere, or regular or irregular trenches or the combination of two or more of the above shapes.

In another example of the present invention, a chemical etching method is used to form a surface texture. Suitable method for glass chemical etching is well known for typical technical people in this area.

In another example of the present invention, a photolithographic etching method is used to form a surface texture. Suitable method for glass photolithographic etching is well known for typical technical people in this area.

The height of the protruding microstructure is typically 500 nm to 2 mm, favorably 2 to 500 µm. The aspect ratio is typically 4 : 1 - 1 : 10, favorably 1 : 1 -1 : 4.

As mentioned above, the glass back sheet of the present invention comprises a continuous or discrete microstructure. In one the better example of the present invention, one major surface adjacent to the solar cell circuit of the glass back sheet comprises a discrete protruding microstructure. The protruding microstructure is evenly distributed on the major surface with a density of 1 - 10⁸ piece / cm², more favorably 10⁴ - 10⁷ pieces / cm².

In one good example of the present invention, a main surface adjacent to the solar cell circuit of The glass back sheet comprises a discrete protruding microstructure. The protruding microstructure forms many discrete islands on the main surface and the protruding microstructure on each island is continuously distributed.

In one good example of the present invention, a main surface adjacent to the solar cell circuit of the glass back sheet comprises a discrete protruding microstructure. The protruding microstructure forms many discrete islands on the main surface and The protruding microstructures on each island is evenly discretely distributed with a density of 1 - 10⁸ pieces / cm², more favorably 10⁴ - 10⁷ pieces / cm².

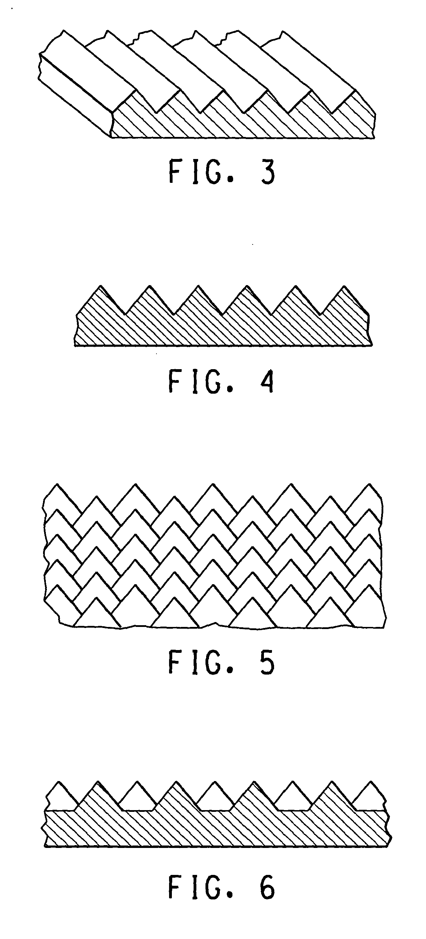

Figure 3 is the scheme of one example of the surface texture on the second surface of the back sheet of a crystalline silicon solar cell sheet. As shown in the profile figure (Figure 4), the surface texture of the second surface comprises many regular trenches, and the profile displays in a triangle shape.

Figure 5 is the scheme of another example of the surface texture on the second surface of the back sheet of a crystalline silicon solar cell sheet. It is more clearly shown in the profile figure (Figure 6) that the surface texture of the second surface comprises many regular pyramids, and The pyramids are evenly distributed on the whole second surface of the back sheet.

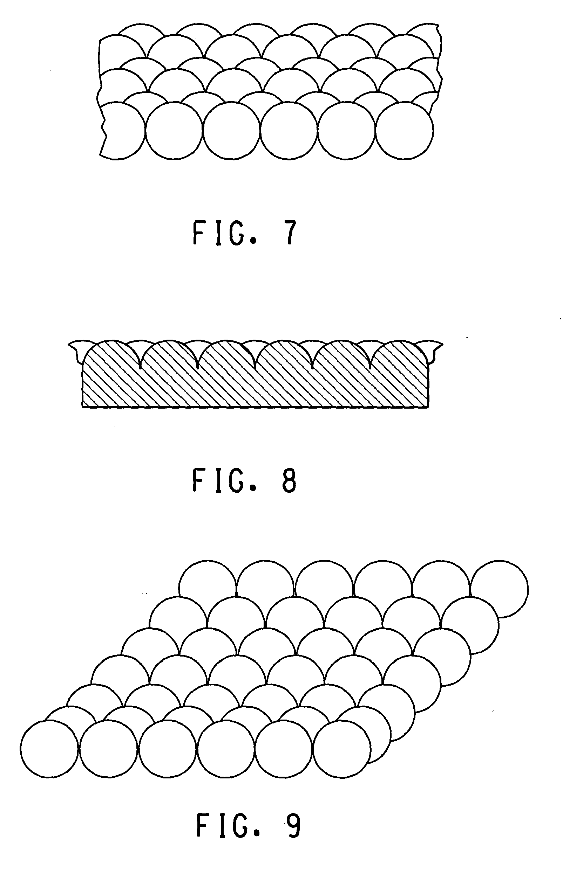

Figure 7 is the scheme of another example of the surface texture on the second surface of the back sheet of a crystalline silicon solar cell sheet. As shown in the profile figure (Figure 8), the surface texture of the second surface comprises many regular hemispheres, and the hemispheres are evenly distributed on the whole second surface of the back sheet.

Figure 9 is still the three dimensional scheme of another example of the surface texture on the second surface of the back sheet of the crystalline silicon solar cell sheet. As shown in the figure, it comprises many coated center-empted clear microspheres.

### 2. Front sheet

The major function of the front sheet is letting the sunlight penetrate the solar cell sheet and prevent the solar cell circuit from the impact of hails. In order to improve the impact resistance of a solar cell sheet and crease its flexigility, the present invention uses a polymeric material as the front sheet of a solar cell sheet.

There is no special limitation for the thickness of the back sheet, as long as it can to a large extent transmit sunlight and provide protection for the solar cell circuit to avoid the impact of hails. In one example of the present invention, The front sheet is made from a plastic material with 2 - 4 mm in thickness.

Suitable plastics material for using as the front sheet of the solar cell sheet of the present invention can be selected from highly transparent materials. The transmittance of a material for the light with wavelength in the range of 350 - 1150 nm is typically greater than 88 %, more favorably greater than 92 %, most favorably greater than 96%. The nonrestrictive examples of the this kind of polymeric materials are one of the e.g. fluorinated polymers, e.g. perfluoroethylene - perfluoropropylene copolymer, ethylene - tetrafluoroethyelene copolymer, tetrafluoroethylene - perfluoroalkoxy vinyl ether copolymer, tetrafluoroethylene - hexafluoropropylene - vinylidene fluoride terpolymer, poly( vinylidene fluoride ), poly( chloro-trifluoro ethylene ), ethylene - chloro-trifluoro ethylene copolymer; liquid crystal polymer; poly( ethylene terephthalate ); poly( ethylene naphthalate ); poly( methyl acrylate )s, e.g. poly (methyl (meth)acrylate ), poly (ethyl (meth)acrylate ); polycarbonate; ethylene - vinyl alcohol copolymer; polyurethane etc.; or the laminated materials with two or more of the above polymers.

In order to improve the light incidence efficiency of the solar cell sheet, a reflection decreasing film / a transmittance improving film can be added on the first surface of the front sheet to improve the incident efficiency of the sunlight.

There is no special limitation for a suitable transmittance improving film. If the front sheet is a plastic material, a suitable transmittance improving film can be a high transmittance material with index of refractive lower than the index of refractive of the front sheet material. In one example of the present invention, the front sheet uses poly( vinylidene fluoride ) and the transmittance improving film uses perfluoroethylene - perfluoropropylene copolymer. If the front sheet material is glass, the suitable material for the transmittance improving film can be a high transmittance material with index of refractive lower than the index of refractive of glass.

In order to improve the light trapping efficiency of the solar cell sheet and thus increase the whole output power, the surface treatment can be carried out on the surface of the front sheet adjacent to the solar cell circuit to increase the light reflectance and reduce the amount of light emission from the inside of the solar cell sheet.

There is no special restriction for the surface treatment of the the front sheet surface, as long as it can improve the light reflectance of the front sheet and thus to prevent photons from emitting from the inside of the solar cell sheet.

In one example of the present invention, the surface treatment of the front sheet comprises embossing press with the main surface of the front sheet adjacent to the solar cell circuit to form a protruding or recessing microstructure. The protruding microstructure comprises continuous or discrete troughs, pyramids, frustums of prisms, cones, frustums of cones, and hemispheres or the combination of two or more the above shapes, etc.

The height of The protruding microstructure is typically 500 nm to 2 mm, more favorably 2 to 500 µm; the aspect ratio is typically 4 : 1 to 1 : 10, more favorably 1 : 1 to 1 : 4.

As described above, the front sheet of the present invention may comprise a continuous or discrete microstructure. In one good example of the present invention, the main surface of the front sheet adjacent to the solar cell circuit comprises a protruding microstructure, wherein the protruding microstructure is evenly distributed on the main surface. The density is 1 - 10⁸ pieces / cm², more favorably 10⁴ - 10⁷ pieces / cm².

In one good example of the present invention, a main surface adjacent to the solar cell circuit of the front sheet comprises a discrete protruding microstructure. The protruding microstructure forms many discrete islands on the main surface and the protruding microstructure on each island is continuously distributed.

In one good example of the present invention, a main surface adjacent to the solar cell circuit of the front sheet comprises a discrete protruding microstructure. The protruding microstructure forms many discrete islands on the main surface and the protruding microstructure on each island is evenly discretely distributed on each island with a density of 1 - 10⁸ pieces / cm², more favorably 10⁴ - 10⁷ pieces / cm².

The protruding microstructure can be prepared with any typical method. For example, a molder with a female structure texture (e.g. press roller) can be used to prepare a microstructure on the polymer sheet by embossing press or a molder can be directly used to mold a microstructure on the polymer sheet. In one example of the present invention, the empty glass beads are coated on the surface of a polymer sheet to form a protruding microstructure.

Figure 3 is the scheme of one example of the surface texture on the second surface of the back sheet of a crystalline silicon solar cell sheet. As shown in the profile figure (Figure 4), the surface texture of the second surface comprises many regular troughs, and the profile displays in a triangle shape.

Figure 5 is the scheme of another example of the surface texture on the second surface of the back sheet of a crystalline silicon solar cell sheet. As more clearly shown in the profile figure (Figure 6), the surface texture of the second surface comprises many regular pyramids, and The pyramids are evenly distributed on the second surface of the whole back sheet.

Figure 7 is the scheme of another example of the surface texture on the second surface of the back sheet of the crystalline silicon solar cell sheet. As shown in the profile figure (Figure 8), the surface texture of the second surface comprises many regular hemispheres, and the hemispheres are evenly distributed on the second surface of the whole back sheet.

Figure 9 is the three dimensional scheme of still another example of the surface texture on the second surface of the back sheet of the crystalline silicon solar cell sheet. As shown in the figure, it comprises many coated center-empted clear microspheres.

In the solar cell sheet of the present invention, the surface texture of the second surface of the front sheet can be the same as or different from that of the second surface of the back sheet. The typical technical people in this field can easily decide a suitable surface texture according to their technical knowledge in combination with the specific requirements, e.g. the process requirements of press embossing, the thickness of the solar cell sheet, etc.

### 3. Polymer Packaging Layer

The solar cell sheet of the present invention uses a typical polymer sealant for packaging a solar cell circuit and adheres the front sheet and back sheet on the solar cell circuit. Example of suitable polymer sealant material is ethylene - vinyl acetate copolymer. The thickness of a polymer packaging layer is typically 100 - 800 µm, more favorably 200 - 750 µm, most favorably 300 - 650 µm.

In one example of the present invention, an electrically conductive adhesive is used to replace the polymeric packaging material. The electrically conductive adhesive can be any electrically conductive adhesive typically used in the field of solar cells.

The present invention also provides a method for the preparation of the solar cell sheet, comprising:
Provide a back sheet;
Provide a front sheet, wherein the front sheet possesses a first surface and a second surface. Form a surface texture that can improve light trapping property on the second surface of the front sheet; and
Place a solar cell circuit between the second surfaces of the back sheet and the front sheet.

The present invention also provides a method for the preparation of the solar cell sheet, comprising:
Provide a back sheet, wherein the back sheet possesses a first surface and a second surface.
Provide a front sheet;
Form a surface texture that can improve light trapping performance on the second surface of the back sheet; and
Place a solar cell circuit between the second surfaces of the back sheet and the front sheet.

The method for the preparation of the solar cell sheet of the present invention can be any typical manufacturing method. In one example of the present invention, use a method for the preparation of the solar cell sheet disclosed in a Chinese Patent CN02143582.0. However, the surface treated front sheet and the back sheet of arbitrarily chosen surface treated plastics or glass replace the front sheet and the back sheet disclosed in the literature.

In the following paragraphs, the present invention will be further described.

### Examples

### Testing Methods

### 1. Light trapping property

Separately prepare the front sheet and the back sheet according to the described method of the present invention. Test the light trapping property of the front sheet, the back sheet, as well as each of their surfaces. Compare the testing results with that of the typical front sheet and back sheet. Separately test the light transmittance of each individual front sheet, back sheet and the reflectance of each surface using a Perkin - Elmer Corporation of the United Sates Lambda 950 UV / Vis / Near IR Spectrometer ( with 150 mm integrator ) and average the testing results in the wavelength of 400 nm to 1100 nm. During testing the reflectance of one surface, in order to prevent the interference of the other surface, carry out a black painting treatment on the other surface using a commercially available ink or an oily mark pen.

### 2. Testing method of the output power of the solar cell

Prepare the front sheet and the back sheet using the describe method of the present invention and package the solar cell according to the structure shown in Figure 2. The used flowchart procedure for assembling and packaging the solar cell comprises single soldering, serial soldering, overlapping, laminating, testing parts, framing, and rinsing. The output power of a solar cell is obtained by testing on a 3500 SLP parts testing instrument (purchased from Spire Company of the United States) and is compared with the output power of the single crystalline silicon solar cell sheet made from a typical front sheet and a typical back sheet.

### Example 1

A perfluoroethylene - perfluoropropylene copolymer sheet (with 50 µm thickness, Teflon^{®} DuPont, United States) was obtained. The copolymer was extruded through a NRM extruder of Davis - Standard Corporation Limited (diameter 4.5 in. and aspect ratio 20 : 1). Then, it was stretched to a film with thickness of 50 µm by passing through a T shaped molder head (width 100 in.) of a center feeding produced by Dupont company of the United States followed by passing through a roller with a smooth surface at room temperature and then a roller gin of BGE Corporation of the United States at 200 °C to form a surface texture with a tetrahedron pyramidal shape on one of its surfaces. The surface texture was evenly distributed on the copolymer surface. The distribution density was 1.0×10⁶ pieces / cm². The height of a single tetrahedron pyramid was 5.0 µm. The length of the base side was 10 µm. The distance of the top points of two adjacent pyramids was 10 µm.

The above method was used to measure the reflectance of the second surface with a surface texture and the result was 6.7 %.

Glass was obtained (tempered glass, purchased from Dongguan Nanbo Solar Energy Glass Corporation of P.R. China, thickness 3.2 mm). The glass surface was embossed to form an evenly tetrahedral pyramidal surface texture on the glass surface by thermal pressing. The surface texture was evenly distributed on the entire surface of the glass sheet. The distribution density was 1.0×10⁶ pieces / cm². The height of a single tetrahedral pyramid was 5.0 µm. The length of the base side was 10 µm. The distance of the top points of two adjacent pyramids was 10 µm.

The above method was used to measure the reflectance of the second surface with a surface texture and the result was 58.4 %.

Then, a layer of aluminum coating was formed with 0.1 µm in thickness on the non-textured surface side of the glass using a vacuum spray method.

The above method was used to measure the reflectance of the whole glass (including the second surface) and the result was 95.8 %.

The perfluoroethylene - perfluoropropylene copolymer was used as the front sheet and the glass as the back sheet to form a solar cell sheet, wherein the textured sides of the front sheet and the back sheet are all placed adjacent to the solar cell circuit.

The above method was used to test the output power of the solar cell and the result was 183 watts.

### Comparative Example 1

The procedure of Example 1 was repeated. However, the perfluoroethylene - perfluoropropylene copolymer sheet and the glass sheet were not treated.

The same method was used to measure the surface reflectance of the perfluoroethylene - perfluoropropylene copolymer sheet and the result was 4.2 %.

The same method was used to measure the reflectance of the second surface of the glass and the result was 9.2 %.

Then, a layer of aluminum coating with 0.1 µm in thickness on the non-textured surface side of the glass was formed using a vacuum spray method.

The perfluoroethylene - perfluoropropylene copolymer was used as the front sheet and the aluminum coated glass was used as the back sheet to form a solar cell sheet. The above method was used to measure the output power of the solar cell and the result was 175 watts.

### Example 2

A perfluoroethylene - perfluoropropylene copolymer sheet (with 50 µm thickness, Teflon^{®} DuPont, United States) was obtained. The copolymer was extruded through a NRM extruder of Davis - Standard Corporation Limited (diameter 4.5 in. and aspect ratio 20 : 1). Then, it was stretched to a film with thickness of 50 µm by passing through a T shaped molder head (width 100 in.) of a center feeding produced by Dupont Company of the United States followed by passing through a roller with a smooth surface at room temperature. A layer of hollow glass microbeads was evenly coated on one surface of the copolymer sheet by painting. The distribution density was 2.3×10⁵ pieces / cm². The mean diameter of the microbeads was 18 µm with the standard deviation of 4 µm.

The above method was used to measure the reflectance of the second surface with a surface texture and the result was 5.6 %.

Glass was obtained (tempered glass, purchased from Dongguan Nanbo Solar Energy Glass Corporation of P.R. China, thickness 3.2 mm). The glass surface was embossed to form an even hemispheric surface texture on the glass surface by thermal pressing. The surface texture was evenly distributed on the entire surface of The glass sheet. The distribution density was 5.1×10⁵ pieces / cm². The height of a single hemisphere was 7.0 µm. The diameter of the base side was 12 µm. The distance of the top points of two adjacent hemispheres was 14 µm.

The above method was used to measure the reflectance of the second surface with surface texture and the result was 47.3 %.

Then, a layer of aluminum coating was formed with 0.1 µm in thickness on the non-textured surface side of the glass sheet using a vacuum spray method.

The above method was used to measure the reflectance of the whole glass (including the second surface) and the result was 94.9 %.

The perfluoroethylene - perfluoropropylene copolymer film was used as the front sheet and the glass as the back sheet to form a solar cell sheet, wherein the textured sides of the front sheet and the back sheet are all placed adjacent to the solar cell circuit.

The above method was used to measure the output power of the solar cell and the result was 181 watts.

### Example 3

A perfluoroethylene - perfluoropropylene copolymer sheet (with 50 µm thickness, Teflon^{®} DuPont ,United States) was obtained. The copolymer was extruded through a NRM extruder of Davis - Standard Corporation Limited (diameter 4.5 in. and aspect ratio 20 : 1). Then, it was stretched to a film with thickness of 50 µm by passing through a T shaped molder head (width 100 in.) of a center feeding produced by EDI company of the United States followed by passing through a roller with a smooth surface at room temperature and then a roller gin of BGE Corporation of the United States at 200 °C to form a surface texture with hemispheric shape on one of its surfaces. The surface texture was evenly distributed on the entire surface of the copolymer sheet. The distribution density was 1.0×10⁶ pieces / cm². The height of a single hemisphere was 5.0 µm. The diameter of the base side was 10 µm. The distance of the top points of two adjacent hemispheres was 10 µm.

The above method was used to measure the reflectance of the second surface with a surface texture and the result was 6.6 %.

Glass was obtained (tempered glass, purchased from Dongguan Nanbo Solar Energy Glass Corporation of P.R. China, thickness 3.2 mm). Even parallel trenches were embossed on the glass surface by thermal pressing. The parallel trenches were evenly distributed on the entire surface of The glass sheet. The height and the width of a single trench were 5.0 µm and 10 µm, respectively. The distance of the top points of two adjacent trenches was 10 µm. The above method was used to measure the reflectance of the second surface with a surface texture and the result was 52.8 %.

Then a layer of aluminum coating was formed with 0.1 µm in thickness on the non-textured surface side of the glass sheet using a vacuum spray method.

The above method was used to measure the reflectance of the whole glass (including the second surface) and the result was 95.3 %.

The perfluoroethylene - perfluoropropylene copolymer was used as the front sheet and the glass as the back sheet to form a solar cell sheet, wherein the textured sides of the front sheet and the back sheet are all placed adjacent to the solar cell circuit.

The above method was used to measure the output power of the solar cell and the result was 182 watts.

### Example 4

A perfluoroethylene - perfluoropropylene copolymer sheet (with 50 µm thickness, Teflon^{®} DuPont ,United States) was obtained. The copolymer was extruded through a NRM extruder of Davis - Standard Corporation Limited (diameter 4.5 in. and aspect ratio 20 : 1). Then, it was stretched to a film with thickness of 50 µm by passing through a T shaped molder head (width 100 in.) of a center feeding produced by Dupont Company of the United States followed by passing through a roller with a smooth surface at room temperature and then a roller gin of BGE Corporation of the United States at 200 °C to form a surface texture with a tetrahedron pyramidal shape on one of its surfaces. The surface texture was evenly distributed on the copolymer surface. The distribution density was 1.0×10⁶ pieces / cm². The height of a single tetrahedron pyramid was 5.0 µm. The length of the base side was 10 µm. The distance of the top points of two adjacent pyramids was 10 µm.

The above method was used to measure the reflectance of the second surface with surface texture and the result was 7.1 %.

Glass was obtained (tempered glass, purchased from Dongguan Nanbo Solar Energy Glass Corporation of P.R. China, thickness 3.2 mm) and the glass surface was embossed to form an even tetrahedral pyramidal surface texture on the glass surface by thermal pressing. The surface texture is evenly distributed on the entire surface. The distribution density was 1.0×10⁶ pieces / cm². The height of a single tetrahedral pyramid was 5.0 µm. The length of the base side was 10 µm. The distance of the top points of two adjacent pyramids was 10 µm.

The above method was used to measure the reflectance of the second surface with surface texture and the result was 58.4 %.

Then a layer of aluminum coating was formed with 0.1 µm in thickness on the non-textured surface side of the glass sheet using a vacuum spray method.

The above method was used to measure the reflectance of the whole glass (including the second surface) and the result was 95.8 %.

The perfluoroethylene - perfluoropropylene copolymer was used as the front sheet and the glass as the back sheet to form a solar cell sheet, wherein the textured sides of the front sheet and the back sheet are all placed adjacent to the solar cell circuit.

The above method was used to measure the output power of the solar cell and the result was 182 watts.

### Example 5

A perfluoroethylene - perfluoropropylene copolymer sheet was obtained (with 50 µm thickness, Teflon^{®} DuPont, United States). The copolymer was extruded through a NRM extruder of Davis - Standard Corporation Limited (diameter 4.5 in. and aspect ratio 20 : 1). Then, it was stretched to a film with thickness of 50 µm by passing through a T shaped molder head (width 100 in.) of a center feeding produced by Dupont Company of the United States followed by passing through a roller with a smooth surface at room temperature and then a roller gin of BGE Corporation of the United States at 200 °C to form a surface texture with hemispheric shape on one of the its surfaces. The surface texture was evenly distributed on The copolymer surface. The distribution density was 1.0×10⁶ pieces / cm². The height of a single hemisphere was 5.0 µm. The diameter of the base side was 10 µm. The distance of the top points of two adjacent hemispheres was 10 µm.

The above method was used to measure the reflectance of the second surface with surface texture and the result was 7.6 %.

A glass was obtained (tempered glass, purchased from Dongguan Nanbo Solar Energy Glass Corporation of P.R. China, thickness 3.2 mm). Embossed even parallel troughs on the glass surface by thermal pressing. The parallel troughs were evenly distributed on the entire surface of The glass sheet. The height and the width of a single trough were 5.0 µm and 10 µm, respectively. The distance of the top points of two adjacent troughs was 10 µm. The above method was used to measure the reflectance of the second surface with surface texture and the result was 47.3 %.

Then a layer of aluminum coating was formed with 0.1 µm in thickness on the non-textured surface side of the glass sheet using a vacuum spray method.

The above method was used to measure the reflectance of the whole glass (including the second surface) and the result was 95.3 %.

The tetrafluoroethylene - perfluoroalkoxy vinyl ether copolymer was used as the front sheet and the glass as the back sheet to form a solar cell sheet, wherein the textured sides of the front sheet and the back sheet are all placed adjacent to the solar cell circuit.

The above method was used to measure the output power of the solar cell and the result was 180 watts.

### Example 6

A perfluoroethylene - perfluoropropylene copolymer sheet was obtained (with 50 µm thickness, Teflon^{®} DuPont, United States). The copolymer was extruded through a NRM extruder of Davis - Standard Corporation Limited (diameter 4.5 in. and aspect ratio 20 : 1). Then, it was stretched to a film with thickness of 50 µm by passing through a T shaped molder head (width 100 in.) of a center feeding produced by Dupont Company of the United States followed by passing through a roller with a smooth surface at room temperature and then a roller gin of BGE Corporation of the United States at 200 °C to form a surface texture with a tetrahedron pyramidal shape on one of its surfaces. The surface texture was evenly distributed on the copolymer surface. The distribution density was 1.0×10⁶ pieces / cm². The height of a single tetrahedron pyramid was 5.0 µm. The length of the base side was 10 µm. The distance of the top points of two adjacent pyramids was 10 µm.

The above method was used to measure the reflectance of the second surface with a surface texture and the result was 6.7 %.

A polycarbonate sheet was obtained (925A, V0, thickness 3.0 mm, US GE Plastics product Lexan®). An even hemispherical surface texture was embossed on the polymer surface by thermal pressing. The surface texture is evenly distributed on the entire surface of the polymer. The distribution density was 1.0×10⁶ pieces / cm². The height of a single hemisphere was 5.0 µm. The length of the base side was 10 µm. The distance of the top points of two adjacent hemispheres was 10 µm.

The above method was used to measure the reflectance of the second surface with surface texture and the result was 10.7 %.

The perfluoroethylene - perfluoropropylene copolymer sheet was used with texture of tetrahedral pyramid as the front sheet and the polycarbonate sheet with hemispheric surface texture as the back sheet to form a solar cell sheet, wherein the textured sides of the front sheet and the back sheet are all placed adjacent to the solar cell circuit.

The above method was used to measure the output power of the solar cell and the result was 174 watts.

### Comparative Example 6

The procedure of Example 6 was repeated. However, no surface micro-treatment was performed on the polymer.

The above method was used to measure the output power of the solar cell and the result was 171 watts.

## Claims

1. A solar cell sheet comprising a back sheet, a plastic front sheet, and a solar cell circuit between the back sheet and the plastic front sheet, wherein the plastic front sheet and/or the back sheet possesses a light receiving first surface and a second surface adjacent to the solar cell circuit, wherein the second surface possesses a surface texture capable of improving light trapping property.

2. The solar cell sheet of claim 1 wherein the plastic front sheet and/or the back sheet are selected from perfluoroethylene - perfluoropropylene copolymer, ethylene - tetrafluoroethyelene copolymer, tetrafluoroethylene - perfluoroalkoxy vinyl ether copolymer, tetrafluoroethylene - hexafluoropropylene - vinylidene fluoride terpolymer, poly( vinylidene fluoride ), ethylene - chloro-trifluoro ethylene copolymer, poly( chloro-trifluoro ethylene ), liquid crystal polymer; poly( ethylene terephthalate ), poly( ethylene naphthalate ), poly( methyl methacrylate ), ethylene - vinyl alcohol copolymer, polycarbonate, polyurethane etc., or the laminated plastic materials with two or more of the above polymers.

3. The solar cell sheet of claim 1, wherein the surface texture of the second surface capable of improving light trapping property is selected from the continuous or discrete pyramids, frustums of pyramids, cones, frustums of cones, hemisphere, or the combination of two or more of the above structures.

4. The solar cell sheet of claim 3 wherein the height of the surface texture is 500 nm - 2 mm and the aspect ratio is 4 : 1 - 1 : 10.

5. The solar cell sheet of claim 4 wherein height of the surface texture is 2µm - 500 µm and the aspect ratio is 1 : 1 - 1 : 4.

6. The solar cell sheet of claim 3 wherein the surface texture is discrete, and the surface texture is evenly distributed on the main surface, and the density is 1 - 10⁸ pieces / cm².

7. The solar cell sheet of claim 6 wherein the density is 10⁴ - 10⁷ pieces / cm².

8. The solar cell sheet of claim 3 wherein the surface texture is discrete and it forms many discrete islands on the main surface, and each island is continuously distributed.

9. The solar cell sheet of claim 3 wherein the surface texture is discrete, and it forms many discrete islands on the main surface, and the texture on each island is evenly discretely distributed, and the density is 1 - 10⁸ pieces / cm².

10. The solar cell sheet of claim 9, wherein the density is 10⁴ - 10⁷ pieces / cm².

11. The solar cell sheet of claim 1, wherein the first surface possesses a layer of transmittance increasing film.

12. A method for the preparation of the solar cell sheet of claim 1, comprising:
Providing a back sheet,
Providing a front sheet, wherein the front sheet has a first surface and a second surface;
Forming a surface texture capable of improving the light trapping property between the back sheet and the front sheet; and
Placing the solar cell circuit between the back sheet and the front sheet.

13. A method for the preparation of the solar cell sheet of claim 1 comprising:
Providing a front sheet;
Providing a back sheet, wherein the back sheet has a first surface and a second surface;
Forming a surface texture capable of improving light trapping property between the back sheet and the front sheet; and
Placing the solar cell circuit between the back sheet and the front sheet.
